# EUROPEAN PATENT APPLICATION

(11) **EP 3 270 511 A1**
(43) Date of publication of application: **17.01.2018**
(21) Application number: 15884691.5
(22) Date of filing: 04.12.2015
(51) Int. Cl.: H03H 7/09, H01F 17/00, H01F 17/04, H01F 27/00, H01F 27/08, H03H 7/01

(54) **NOISE FILTER**

(30) Priority: 11.03.2015 JP 2015047908; 12.05.2015 WO PCT/JP2015/063552
(71) Applicant: Mitsubishi Electric Corporation, Chiyoda-ku Tokyo 100-8310 (JP)
(72) Inventor: HARUNA Nobuyuki, Tokyo 100-8310 (JP); TAKAHASHI Keita, Tokyo 100-8310 (JP); SHIMOHATA Kenji, Tokyo 100-8310 (JP); MIYAKAWA Naruto, Tokyo 100-8310 (JP)
(74) Representative: Sajda, Wolf E.
(86) International application number: PCT/JP2015/084152
(87) International publication number: WO 2016/143207

(57) **Abstract**

Obtain a noise filter in which an attenuation effect of the noise filter is maintained to a high frequency wave, and it can be prevented that the noise filter is set at a high temperature. Ground patterns (19a, 19b, 24a, 24b) of ground conductors (19, 24) are extended to the outside of winding patterns so as to be arranged at positions (29 through 32) at which the ground patterns (19a, 19b, 24a, 24b) are faced to input-output terminal positions (3, 6, 14, 18) of the winding patterns of a winding conductor (100), and slits (20 through 23) and slits (25 through 28), which separate portions which are arranged around a magnetic material core (400), are provided at the ground patterns (19a, 19b, 24a, 24b) of the ground conductors (19, 24).

## Description

### BACKGROUND OF THE INVENTION

### Technical Field

The present invention relates to a noise filter which attenuates a noise which is caused in accordance with a switching operation of a semiconductor element in an electric power conversion device.

### Background Art

There is an electric power conversion device as a device for supplying an electric power, which has a variable frequency and a variable voltage, to a load such as a motor. In the electric power conversion device, semiconductor elements of an inverter portion and a converter portion in the device are composed of a power semiconductor, whereby a voltage is increased or decreased in accordance with a switching operation of the power semiconductor, and an AC voltage, which has a variable frequency and a variable voltage, is generated, and an AC electric power is supplied to a load such as a motor.

It is generally known that a conductive noise is caused by a charge-discharge operation in accordance with, for example, an electric potential variation at a neutral point of a U phase, a V phase, and a W phase of an output power, or a parasitic inductance in the device, or a parasitic capacitance.

An electric current, which is flowed through a plurality of wires with an identical phase and an identical amplitude in a conductive noise and is passed through a metallic case of a device, of which return passage is a grounding line and is set at a grounding electric potential, or through the ground, is referred to as a common mode electric current. In order to reduce a conductive noise, a reduction countermeasure of a common mode electric current (or referred to as a common mode noise) is an essential countermeasure.

In order to reduce the common mode noise, as the above-described conductive noise, which is generated in accordance with a switching operation or the like of a semiconductor element, a common mode coil, at which a conductor is wound around a magnetic material core, is used. The common mode coil has an effect as a common mode filter in which the common mode noise is reduced by using an inductance of a coil, at which a winding is provided to the magnetic material core, and a resistance component of a magnetic material. Moreover, when the common mode coil and a capacitor, which reduces the common mode noise by using small impedance between the capacitor and a grounding portion, are combined and used, the common mode coil and the capacitor function as a filter by which the common mode noise is more reduced.

However, in the common mode noise filter in which an inductor and a capacitor are combined, there have been problems in that terminal connecting portions are increased, and a complicated assembly work is caused, and the whole of the device is enlarged because an installation area and an installation volume of a component are increased.

As a method by which the above-described problems are solved, for example, in Patent Document 1, there is a described compact common mode noise filter in which a component, which is integrated by sandwiching a dielectric between a winding of a common mode coil and a grounding line, is fitted to a magnetic material which is composed of a E-shaped core and an I-shaped core or is composed of two E-shaped cores, whereby an installation area of the whole of the filter, in which an inductance and a conductance are integrally configured, is reduced.

Moreover, in Patent Document 2, there is a described noise filter in which a dielectric is sandwiched between winding patterns and ground patterns, and an inductor and a capacitor are integrated by laminating a plurality of blocks which is configured by connecting the winding patterns and the ground patterns each other via a through hole.

### List of Citations

### Patent Document

- Patent Document 1:: Japanese Laid-Open Patent Publication
JP 2000-312 121 A
- Patent Document 2:: Japanese Utility Model Publication
JP S62-134 213 U.

### SUMMARY OF THE INVENTION

### Problems to Be Solved by the Invention

However, in each of the conventional noise filters which are described in Patent Document 1 and Patent Document 2, a grounding line is pulled from the inside of the noise filters and is connected to a grounding electric potential,, so that there have been problems in that the grounding line is elongated, and a characteristic of a capacitor is varied from a capacity characteristic to an induction characteristic at a relatively low frequency, and a noise reduction effect cannot be maintained to a high frequency wave.

Moreover, for example, in a case of an electric power conversion device for being mounted in a vehicle, heat is propagated from an engine room, whereby the electric power conversion device is disposed, for example, in a temperature environment in which a temperature is higher than or equal to 50 °C, and moreover, a large electric current, which is larger than or equal to several dozen amperes, is flowed through a circuit of the electric power conversion device, whereby an environment, in which a noise filter is disposed, is set at a high temperature.

When a magnetic material and a dielectric, which compose a filter, are set at a high temperature, a characteristic is deteriorated, and endurance, such as an insulation capability deterioration, is deteriorated, so that, for example, it is required that an extra component, by which joule heat of a winding is radiated, is provided, and as a result, there has been a problem in that the filter is enlarged.

The present invention has been made to solve the above-described problems, and an attenuation effect of a noise filter is maintained to a high frequency wave.

### Means for Solving Problems

A noise filter of the present invention includes a winding conductor which is composed of a conductor having a plane shape, and composes winding patterns which are arranged with a layer shape and electrically connect a component between layers; ground conductors, which are arranged in a state where a dielectric is sandwiched between the ground conductors and conductors of the winding patterns, and compose ground patterns; and a magnetic material core to which the winding patterns are wound; wherein the ground patterns are extended to the outside of the winding patterns so as to be arranged at positions where the ground patterns are faced to input-output terminals of the winding patterns; and slits, which separate portions which are arranged around the magnetic material core, are provided at the ground patterns of the ground conductors.

### Effects of the Invention

According to the noise filter of the present invention, the noise filter can be maintained to a high frequency wave at a frequency band at which an effect of the noise filter is realized.

### BRIEF DESCRIPTION OF THE DRAWINGS

- FIG. 1: is an oblique perspective view illustrating a noise filter according to Embodiment 1 of the present invention;
- FIGS. 2: are plan views illustrating winding patterns of the noise filter according to Embodiment 1 of the present invention;
- FIGS. 3: are plan views illustrating ground patterns of the noise filter according to Embodiment 1 of the present invention;
- FIGS. 4: are explanatory views for explaining passages of noise electric currents which are flowed through a capacitor of the noise filter according to Embodiment 1 of the present invention;
- FIGS. 5: are explanatory views for explaining passages of noise electric currents which are flowed through the capacitor of the noise filter according to Embodiment 1 of the present invention;
- FIG. 6: is an explanatory view for explaining an equivalent circuit of a common mode of the noise filter according to Embodiment 1 of the present invention;
- FIG. 7: is an explanatory view for explaining an equivalent circuit of a common mode of a noise filter;
- FIGS. 8: are explanatory views for explaining passages of noise electric currents which are flowed through the capacitor of the noise filter according to Embodiment 1 of the present invention;
- FIGS. 9: are explanatory views for explaining passages of noise electric currents which are flowed through the capacitor of the noise filter according to Embodiment 1 of the present invention;
- FIG. 10: is an oblique perspective view for explaining a grounding configuration of ground patterns at the noise filter according to Embodiment 1 of the present invention;
- FIG. 11: is an oblique perspective view for explaining a grounding configuration of ground patterns at the noise filter according to Embodiment 1 of the present invention;
- FIG. 12: is an oblique perspective view illustrating a noise filter according to Embodiment 2 of the present invention;
- FIG. 13: is a cross-sectional view along a cutting line ("A - A" arrow view) which is indicated in FIG. 1;
- FIG. 14: is an oblique perspective view illustrating a noise filter according to Embodiment 3 of the present invention;
- FIG. 15: is a cross-sectional view along a cutting line ("B - B" arrow view) which is indicated in FIG. 14;
- FIGS. 16: are plan views illustrating winding patterns of the noise filter according to Embodiment 3 of the present invention;
- FIGS. 17: are plan views illustrating winding patterns of the noise filter according to Embodiment 3 of the present invention;
- FIGS. 18: are plan views illustrating ground patterns of the noise filter according to Embodiment 3 of the present invention;
- FIG. 19: is a cross-sectional view illustrating a cross section of a noise filter according to Embodiment 4 of the present invention;
- FIGS. 20: are plan views illustrating winding patterns of the noise filter according to Embodiment 4 of the present invention;
- FIGS. 21: are plan views illustrating ground patterns of the noise filter according to Embodiment 4 of the present invention;
- FIG. 22: is an explanatory view for explaining an equivalent circuit of a common mode of the noise filter according to Embodiment 4 of the present invention;
- FIG. 23: is an oblique perspective view illustrating a noise filter according to Embodiment 5 of the present invention;
- FIGS. 24: are oblique perspective views illustrating board portions at which windings of the noise filter according to Embodiment 5 of the present invention and the ground are integrated;
- FIGS. 25: are plan views illustrating winding patterns and grounds patterns of the noise filter according to Embodiment 5 of the present invention;
- FIGS. 26: are oblique perspective views illustrating coil portions of the noise filter according to Embodiment 5 of the present invention; and
- FIG. 27: is a cross-sectional view along a cutting line ("C - C" arrow view) which is indicated in FIG. 23.

### MODE FOR CARRYING OUT THE INVENTION

### Embodiment 1

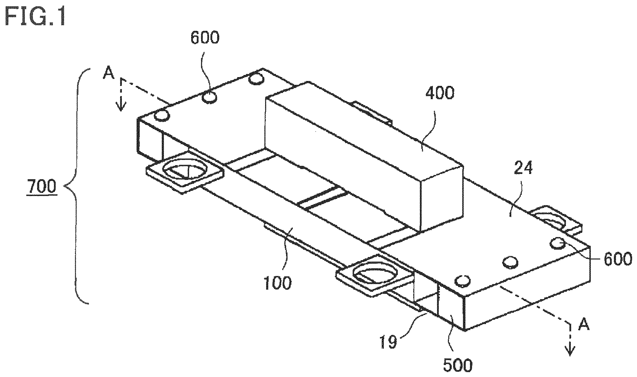

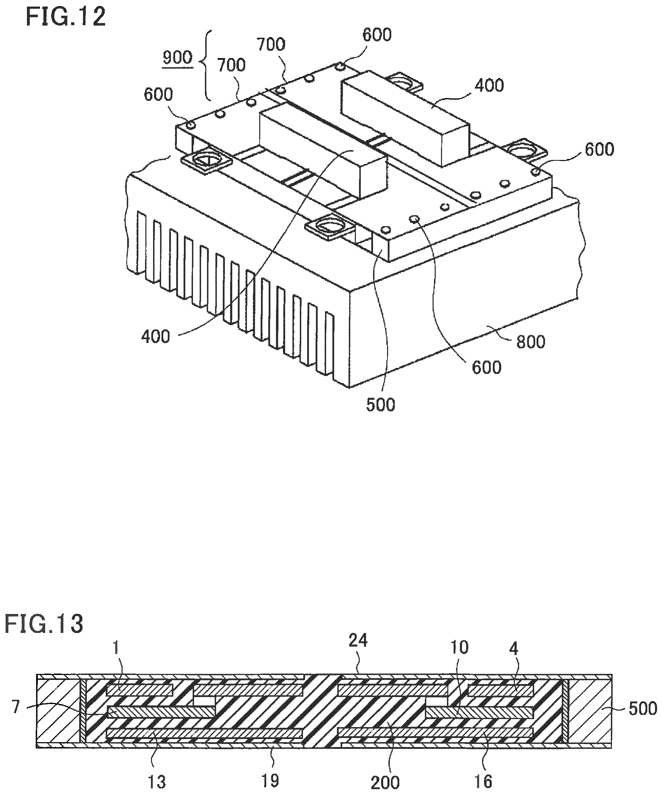

FIG. 1 is an oblique perspective view for explaining a noise filter (or referred to as a common mode noise filter) according to Embodiment 1, and FIG. 13 is a cross-sectional view along an "A - A" line of the common mode noise filter which is indicated in FIG. 1.

A noise filter (common mode noise filter) 700, which is indicated in FIG. 1, is schematically composed of a winding conductor 100, which is composed of winding patterns, a dielectric (or referred to as a dielectric resin) 200 by which a material between the dielectric and the winding conductor is isolated, a ground conductor 19 and a ground conductor 24, which compose ground patterns, and a magnetic material core 400.

The winding conductor 100 is used as windings which are composed of a conductor having a plane shape. The windings are formed with a board configuration, and winding patterns are formed with a board shape at the winding conductor 100, and the dielectric resin 200 (refer to FIG. 13) for insulating is sandwiched between the windings.

Moreover, an edge surface of the conductor is covered by a dielectric resin in order to enhance an insulation capability. In an example according to Embodiment 1, two-turn windings are wound, and the two-turn windings are composed of a three-layered conductor layer, and ground layers is composed of a first layer and a fifth layer.

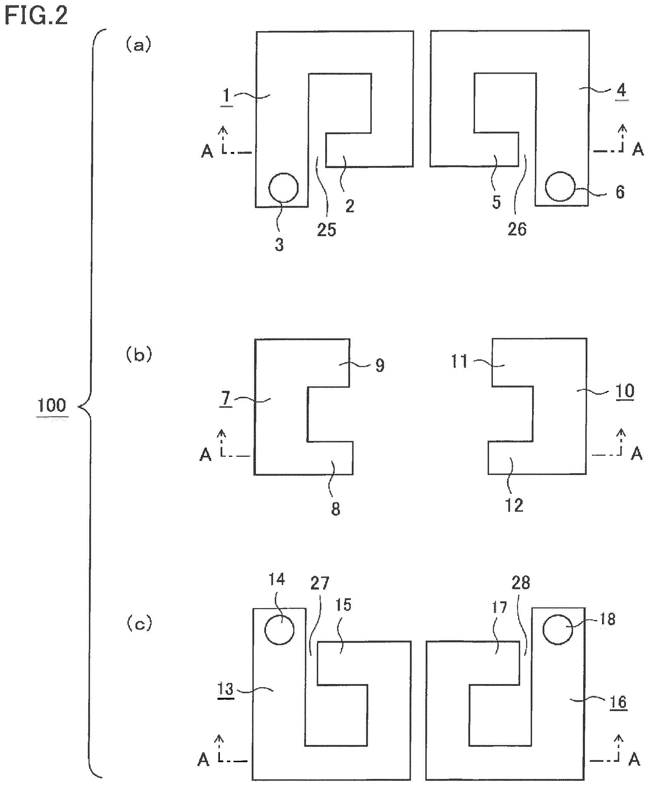

FIGS. 2 are plan views for explaining winding patterns according to Embodiment 1. FIGS. 2 indicate each of a winding pattern 1, a winding pattern 7, and a winding pattern 13, which compose the winding patterns at a positive pole side of a second layer, a third layer, and a fourth layer, which are arranged as indicated in FIG. 13, and each of a winding pattern 4, a winding pattern 10, and a winding pattern 16, which compose the winding patterns at a negative pole side.

In other words, FIG. 2(a) indicates the winding patterns at the positive pole side of the second layer and the winding patterns at the negative pole side of the second layer. FIG. 2(b) indicates the winding patterns at the positive pole side of the third layer and the winding patterns at the negative pole side of the third layer. FIG. 2(c) indicates the winding patterns at the positive pole side of the fourth layer and the winding patterns at the negative pole side of the fourth layer.

A winding pattern input terminal 3 at the positive pole side, a winding pattern input terminal 6 at the negative pole side, a winding pattern output terminal 14 at the positive pole side, and a winding pattern output terminal 18 at the negative pole side are provided at each of the winding patterns. An end portion (or referred to as a connection position) 2, an end portion 8, an end portion 5, and an end portion 12, which are positioned between terminals of the second layer and the third layer (between winding patterns), and an end portion 9, an end portion 15, an end portion 11, and an end portion 17, which are positioned between terminals of the third layer and the fourth layer, are electrically connected by using, for example, an inner via hole (IVH).

In this case, when an electric current density at a via hole portion is enhanced, a heating value at a via hole position is increased, so that it is desirable that a plurality of via holes are formed in a state where a cross-sectional area of the via hole is similar to a cross-sectional area of a winding pattern. Moreover, a slit 25 and a slit 26 are respectively formed at the winding pattern 1 and the winding pattern 4, and a slit 27 and a slit 28 are respectively formed at the winding pattern 13 and the winding pattern 16.

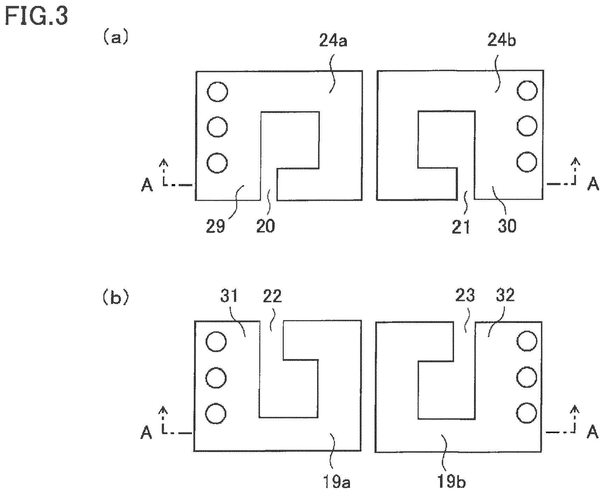

FIGS. 3 are plan views for explaining ground patterns according to Embodiment 1. FIG. 3(a) indicates a ground pattern 24a at the positive pole side and a ground pattern 24b at the negative pole side, which compose the ground patterns at the first layer, and FIG. 3(b) indicates a ground pattern 19a at the positive pole side and a ground pattern 19b at the negative pole side, which compose the ground patterns at the fifth layer, and capacitors to the ground are respectively formed between the first layer and the second layer and between the fourth layer and the fifth layer.

A capacitance of a capacitor is proportional to an area of a conductor which is faced to the capacitor, so that, in order to form a maximum capacitance, when the ground pattern 24a, the ground pattern 24b, the ground pattern 19a, and the ground pattern 19b are provided at a position where the ground patterns are entirely faced to the winding pattern 1, the winding pattern 4, the winding pattern 13, and the winding pattern 16, a maximum faced area is realized, and a maximum capacitance is realized.

The ground pattern 24a, the ground pattern 24b, the ground pattern 19a, and the ground pattern 19b are extended to the outside of the winding patterns so as to be arranged at a position 29, a position 30, a position 31, and a position 32, at which the ground patterns are faced to the winding pattern input terminal 3 and the winding pattern input terminal 6 of the winding patterns, and the winding pattern output terminal 14 and the winding pattern output terminal 18.

In other words, for example, the ground pattern 24a and the ground pattern 24b are arranged in a state where the areas of the ground pattern 24a and the ground pattern 24b are wider than the areas of the winding pattern 1 and the winding pattern 4, which are respectively faced to the ground patterns.

Moreover, a slit 20 and a slit 21 are respectively formed at the ground pattern 24a and the ground pattern 24b, and a slit 22 and a slit 23 are respectively formed at the ground pattern 19a and the ground pattern 19b. When the slits are not formed, a high frequency wave impedance of the winding is shorted in accordance with a magnetic linkage of the winding pattern toward the winding in a state where the ground pattern is conducting around the magnetic material core 400, an effect of a high impedance at a high frequency wave, in a state where the winding is provided to the magnetic material core 400, is lost. However, when the slits are provided, the above-described problem is not caused.

In the noise filter according Embodiment 1, the capacitors (capacitors to the ground) are formed between the winding patterns at the positive pole side and the negative pole side of the second layer and the ground patterns at the first layer, and between the winding patterns at the positive pole side and the negative pole side of the fourth layer and the ground patterns at the fifth layer. The capacitors to the ground have a low impedance with respect to a high frequency wave noise current of a common mode, so that a noise electric current can be flowed to a ground layer, and only the noise electric current can be attenuated.

At a dielectric layer, by which a capacitance is formed, between the winding patterns and a ground layer, when the dielectric layer has a higher dielectric ratio or has a thinner thickness, the capacitance is enhanced, so that a noise attenuation effect is enhanced.

Moreover, the both winding patterns of the positive pole side and the negative pole side are wound around the magnetic material core 400, in which a permeability ratio is high at a high frequency wave, which is, for example, a ferrite core, an amorphous core, or a metallic magnetic material core having a crystal characteristic. Directions of interlinkage magnetic fluxes to a core of common mode noise electric currents, which are flowed through the both windings at the positive pole side and the negative pole side, are identical each other, so that the identical directions are effective to the attenuation of the common mode noises which are flowed to the positive pole and the negative pole.

Although the magnetic material core 400 according to Embodiment 1 is composed of a core (or referred to as a UU core), which is formed by combining two U-shaped cores, or a core (or referred to as a UI core), which is formed by combining two kinds of a U-shaped core and a I-shaped core, the magnetic material core 400 may be composed of a core (or referred to as a EE core), which is formed by combining two E-shaped cores, or a core (or referred to as a EI core), which is formed by combining two kinds of a E-shaped core and a I-shaped core.

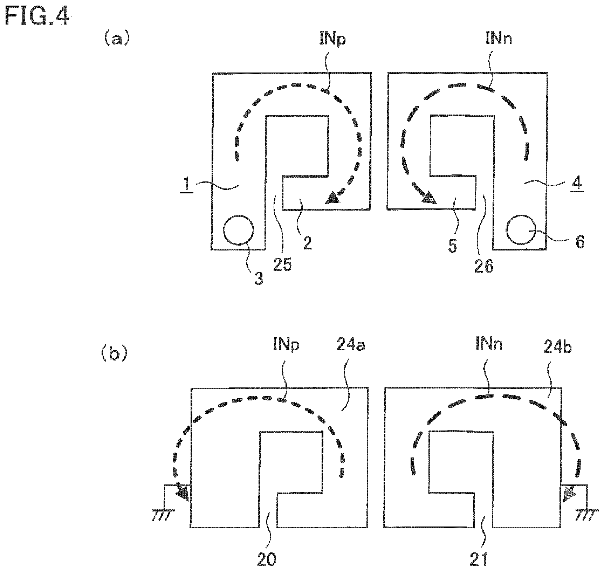

FIGS. 4 are views which schematically indicate passages of noise electric currents of the positive pole and the negative pole, which are flowed from the winding pattern at the second layer to the ground pattern at the first ground pattern according to Embodiment 1. FIG. 4(a) indicates the winding pattern at the positive pole side of the second layer and the winding pattern at the negative pole side of the second layer. Moreover, FIG. 4(b) indicates the ground pattern at the positive pole side and the ground pattern negative pole side, which compose the ground patterns at the first layer.

As indicated in FIGS. 4, when the slit 20 and the slit 21 are respectively provided at the ground pattern 24a and the ground pattern 24b, and a pattern, which is orbited around the magnetic material core 400, is not conducting, a direction of a nose electric current, which is flowed through the winding pattern, at an outward passage, is reverse to a direction of a nose electric current, which is passed through the ground pattern and is flowed to a grounding electric potential, at a return passage, and the generated magnetic fluxes are reversely counteracted, so that an inductance is not generated.

Directions of a noise electric current INp at the positive pole side and a noise electric current INn at the negative pole side are indicated as the broken lines. In other words, when the noise filter is indicated by using an equivalent circuit view of a common mode (although an equivalent circuit of a core is schematically indicated by using only self-inductances L for each of one turn and mutual inductances M at a first turn and a second turn, when the equivalent circuit is exactly indicated, the equivalent circuit includes a resistance component and a capacity component.

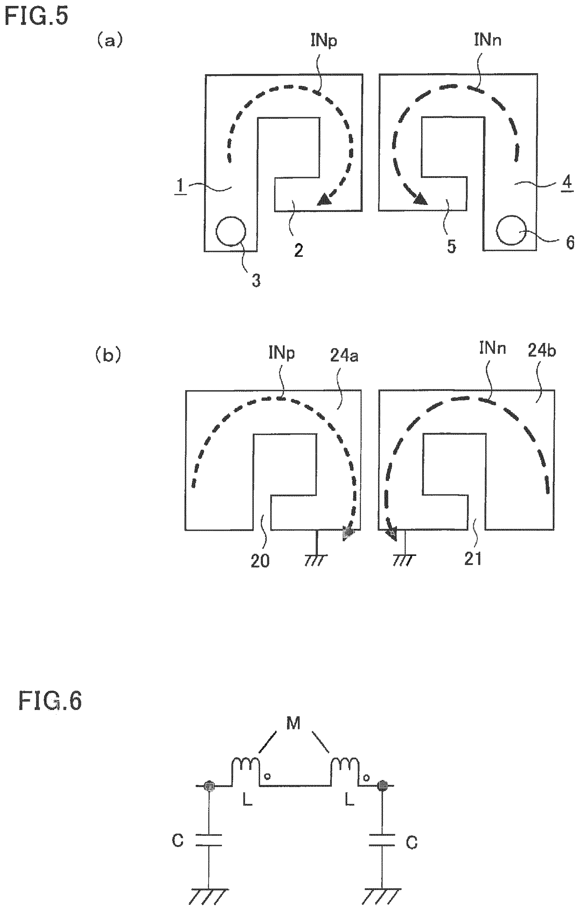

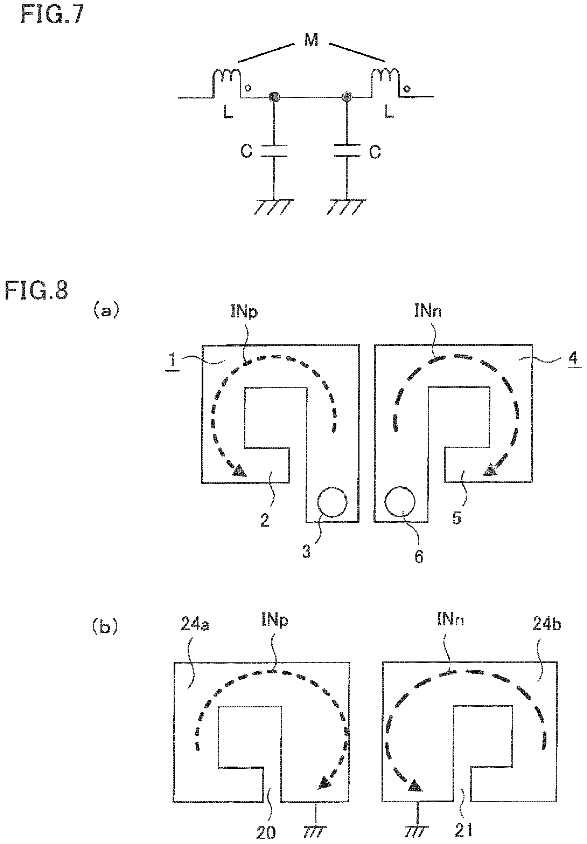

The resistance component and the capacity component are not required in this explanation, so that only the self-inductances L are indicated), the equivalent circuit is not indicated as FIG. 7, and the equivalent circuit is indicated as FIG. 6, so that a noise reduction effect can be enhanced. In addition, a relation between capacitors C to the ground and the mutual inductances M is indicated as FIG. 6. Moreover, it is required that the ground pattern 19a and the ground pattern 19b at the output side and the winding pattern 13 and the winding pattern 16 are similarly arranged.

Moreover, the slit 20 and the slit 21 of the ground pattern 24a and the ground pattern 24b, which are indicated in FIG. 4A, 4B, are arranged at the positions where the slit 20 and the slit 21 are overlapped to the slit 25 and the slit 26 of the winding pattern 1 and the winding pattern 4, which are respectively faced to the ground pattern 24a and the ground pattern 24b via a dielectric, and a maximum capacitance condition is realized in a state where a position of the slits of the ground patterns and a position of the slits of the winding patterns are overlapped as described above, and a maximum attenuation effect of the common mode noise filter is realized.

The above-described relation between the positions of the slits and the attenuation effect is similar to a relation between the positions of the slit 22 and the slit 23 of the ground pattern 19a and the ground pattern 19b at the output side and the slit 27 and the slit 28 of the winding pattern 13 and the winding pattern 16.

On the other hand, when the ground patterns are grounded as indicated in FIGS. 5, a noise electric current is flowed to a grounding electric potential only by an outward passage, so that an interlinkage magnetic flux to a core is generated, and the magnetic flux is linked to an inductance of a two-turn winding of the winding patterns.

In addition, FIG. 5(a) indicates the winding pattern at the positive pole side at the second layer and the winding pattern at the negative pole side at the second layer. Moreover, FIG. 5(b) indicates the ground pattern at the positive pole side and the ground pattern at the negative pole side, which compose the ground patterns at the first layer.

In the above-described case, the noise filter is indicated as an equivalent circuit in FIG. 7, and a noise attenuation effect is greatly low in comparison with an equivalent circuit in FIG. 6. Even when a winding pattern, which is wound from the inside, is used, it is required that an equivalent circuit is similarly considered, and when the noise filter is grounded as FIGS. 8, an equivalent circuit is indicated as FIG. 6.

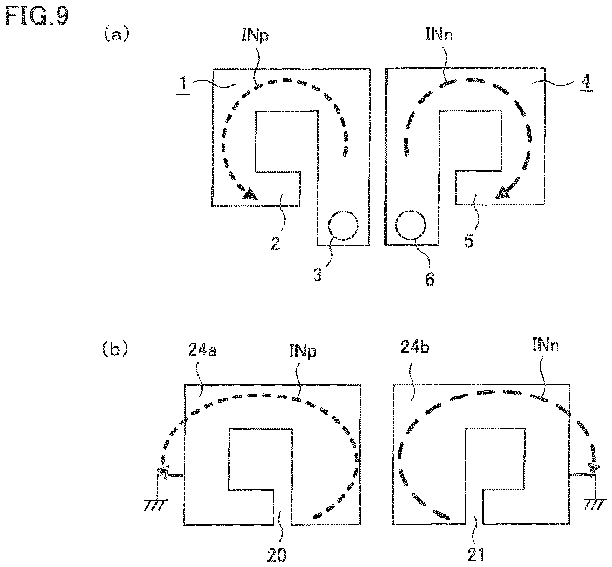

However, when the noise filter is grounded as FIGS. 9, an equivalent circuit is indicated as FIG. 7, so that a noise attenuation effect, in a state where the noise filter is grounded as FIGS. 8, are higher than a noise attenuation effect, in a state where the noise filter is grounded as FIGS. 9. In addition, the above-described mechanism is applied to a relation between the winding patterns at the fourth layer and the ground patterns at the fifth layer.

In addition, FIG. 8(a) indicates the winding pattern at the positive pole side at the second layer and the winding pattern at the negative pole side at the second layer. FIG. 8(b) indicates the ground pattern at the positive pole side and the ground pattern at the negative pole side, which compose the ground patterns at the first layer.

Moreover, FIG. 9(a) indicates the winding pattern at the positive pole side at the second layer and the winding pattern at the negative pole side at the second layer. FIG. 9(b) indicates the ground pattern at the positive pole side and the ground pattern at the negative pole side, which compose the ground patterns at the first layer.

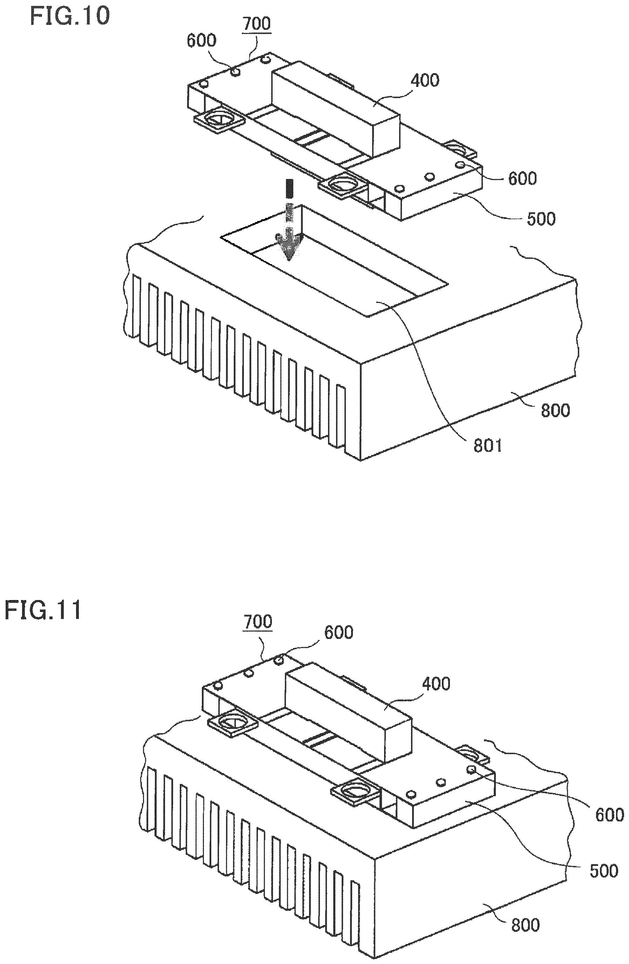

FIG. 10 and FIG. 11 are oblique perspective views for explaining a grounding configuration of the ground patterns according to Embodiment 1. In an electric power conversion device, energy, which is lost in a power semiconductor portion, is converted to heat so as to be generated. Moreover, in the electric power conversion device, a large electric current with several dozen amperes through several hundred amperes is flowed through a winding in order to transfer a higher electric power, so that large heat is generated from a winding wiring. Therefore, there are many cases in which a radiating fin 800 is attached to the noise filter in the electric power conversion device. On the other hand, the radiating fin 800 is a metallic block, so that the radiating fin 800 is used as a ground electric potential.

In the nose filter according to Embodiment 1, the radiating fin 800 is used for cooling the nose filter, and is used as the ground to which a capacitor to the ground is grounded. A groove (hollow portion) 801 is provided at the radiating fin 800, and when the nose filter is attached as indicated FIG. 10 and FIG. 11, a low portion of the magnetic material core 400 is fitted to the groove 801 so as to be installed, and the ground patterns of the ground conductor 19 are contacted to the radiating fin 800.

The nose filter is attached to the radiating fin 800 in a low contact resistance state by using conductive screws 600 in a state where a conductor spacer 500 is sandwiched between the ground conductor 19 and the ground conductor 24. The ground conductor 24 is also connected so as to be grounded. When an amorphous material, a fine material, or a MnZn (manganese zinc) ferrite material, of which electric conductivity is high, is used for the magnetic material core 400, the nose filter is insulated between the magnetic material core 400 and the radiating fin 800.

In the common mode noise filter according to Embodiment 1, the ground patterns are extended to the outside of the winding patterns so as to be arranged at an input-output terminal position, and moreover, the ground patterns are not lines, and the ground patterns are the patterns having a plane shape, so that the noise filter can be grounded by using a small self-inductance.

In a conventional noise filter, when a capacitor has, for example, a capacitance which is greater than or equal to InF, and when self-inductances of wirings at the inside and the outside of the capacitor is greater than or equal to 10nH, the capacitor has a self-resonance frequency at a frequency which is lower than equal to 50 MHz, so that a characteristic of the capacitor is changed from a capacitance characteristic to an induction characteristic at a frequency which is higher than equal to 50 MHz, and an effect, by which a nose electric current is reduced, is decreased when a frequency is increased.

On the other hand, when the noise filter can be grounded as described in Embodiment 1 in a state where a ground pattern configuration having a plane shape and a wide width is maintained, the self-resonance frequency is higher than or equal to 50 MHz even when the capacitance is greater than or equal to InF, in other words, even when the self-resonance frequency is higher than or equal to 50 MHz, a common mode noise filter, by which a noise attenuation effect is realized, can be realized.

Moreover, the common mode noise filter 700 according to Embodiment 1 has a board configuration, whereby heat is easily transferred in a vertical direction with respect to a surface of a board, and a width of the ground patterns is wide, so that a noise can be effectively transferred to the radiating fin 800.

As a result, the cross-sectional areas of the winding patterns, which compose the common mode noise filter 700, can be reduced, and moreover, an extra component, by which joule heat of the winding patterns is radiated, is not required, so that an effect for downsizing the whole of the noise filter is realized.

In the noise filter according Embodiment 1, the noise filter is explained by using a pattern in which the winding is wound from the outside as indicated in FIGS. 4. In a configuration in which the winding is wound from the outside, a pulled length of the ground layer is shorter than a pulled length of the ground layer in a case where the winding is wound from the inside as indicated in FIGS. 8, whereby a wiring inductance of a capacitor is reduced, so that a noise reduction effect can be maintained to a higher frequency.

Moreover, on the other hand, when the winding is wound from the inside, the number of pattern layers, in a case where the identical number of patterns is realized, is smaller than the number of pattern layers when the winding is wound from the outside. Therefore, as a result, a total length of the winding patterns is shortened, and a heating value can be suppressed at a small value. The outside, which is described above, indicates an outer circumference side (outside) of a common mode magnetic flux, by which a closed magnetic passage is formed in a magnetic material, in a UU core or a UI core.

Moreover, in the noise filter according Embodiment 1, although a case, in which the board-type winding patterns are single-phase winding patterns, is described, the winding patterns are not limited to the single-phase winding patterns, and the noise filter can be similarly configured when the winding patterns are three-phase winding patterns, and the winding patterns are magnetically linked each other, so that a similar operation effect can be obtained.

### Embodiment 2

FIG. 12 is an oblique perspective view for explaining a common mode noise filter according to Embodiment 2. The noise filter according to Embodiment 2 is a two-step noise filter 900 which is configured by using the two noise filters (common mode noise filters) 700 which are indicate in Embodiment 1. The noise filter 900 is configured as a two-step noise filter, whereby a noise attenuation effect is greatly improved. It is similar to the ground patterns according to Embodiment 1 that the ground patterns according to Embodiment 2 are extended to the outside of winding patterns so as to be arranged at an input-output terminal position.

Moreover, in a case of a common mode noise filter which is configured by combining an inductor and a capacitor, which are conventional and individual components, tow inductors are electrically connected or the inductor and the capacitor are electrically connected, so that it is required that a terminal is newly provided, and an arrangement area of the noise filter is larger than a sum of arrangement area of each of the components by which the noise filter is simply configured.

On the other hand, the common mode noise filter according to Embodiment 2 is a board-type noise filter in which a winding conductor and a ground conductor are configured by using a pattern, whereby a winding pattern and a ground pattern of the two-step noise filter can be integrally formed, so that a grounding area is not increased in accordance with a terminal connection, and the common mode noise filter is downsized.

### Embodiment 3

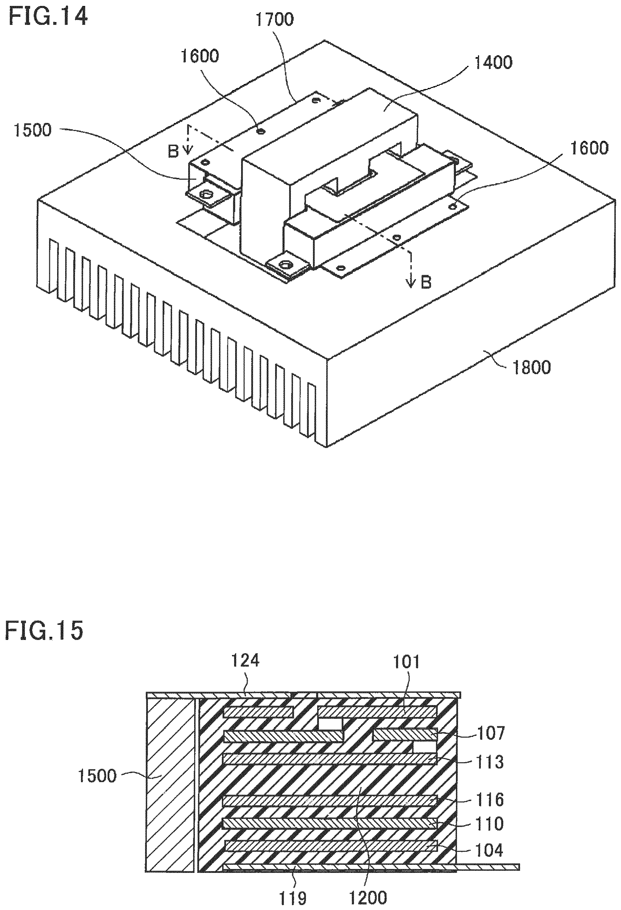

FIG. 14 is an oblique perspective view illustrating a noise filter according to Embodiment 3, and FIG. 14 indicates a state in which a radiating fin 1800 is attached. FIG. 15 is a cross-sectional view along a "B - B" line of the common mode noise filter which is indicated in FIG. 14. It is similar to the ground patterns according to Embodiment 1 that ground patterns according to Embodiment 3 are extended to the outside of winding patterns so as to be arranged at an input-output terminal position.

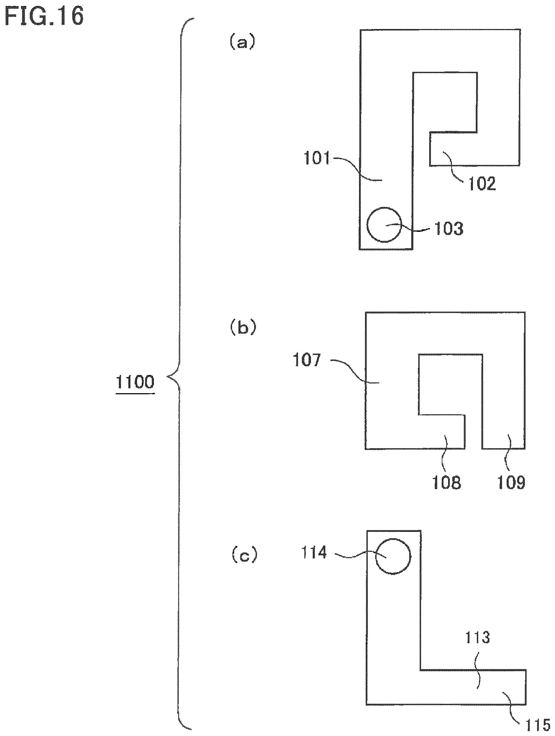

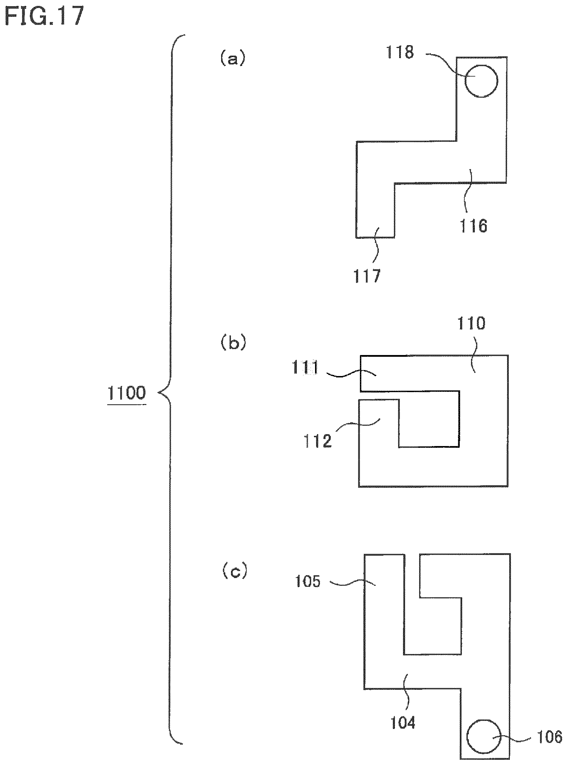

The noise filter (common mode noise filter) 1700, which is indicated in FIG. 14, is schematically configured, as similar to the noise filter according to Embodiment 1, by using a winding conductor 1100 (refer to FIGS. 16 and FIGS. 17) which composes winding patterns, a dielectric (or referred to as a dielectric resin) 1200 by which a component between the dielectric and the winding conductor is insulated, a ground conductor which composes a ground pattern 119 and a ground pattern 124, and a magnetic material core 1400.

A groove is provided, as similar to the groove according to Embodiment 1, at the radiating fin 1800, and a low portion of the magnetic material core 1400 is fitted to the groove so as to be installed. Moreover, the noise filter is attached to the radiating fin 1800 by using conductive screws 1600, and the attachment configuration of the noise filter according to Embodiment 3 is similar to the attachment configuration of the noise filter and the radiating fin by using the conductive screws 600 according to Embodiment 1.

The magnetic material core 1400 has a configuration in which two cores having a E shape (E-shaped cores) are combined, or a E-shaped core and a core having a I shape (I-shaped core) are combined.

The winding conductor 1100 is used as windings which are composed of a conductor having a plane shape. The windings are formed with a board configuration, and the dielectric resin 1200 (refer to FIG. 15) for insulating is sandwiched between the windings. Moreover, an edge surface of the conductor is covered by a dielectric resin in order to enhance an insulation capability. In an example according to Embodiment 3, two-turn windings are wound, and the two-turn windings are respectively composed of three-layered conductor layers at a positive pole side and a negative pole side, and a first layer and a eighth layer compose ground layers.

In Embodiment 3, the noise filter is explained by using an example in which the E-shaped cores are used as the magnetic material core 1400, and the magnetic material core 1400 is set at a position of an upper-lower relation at a positive pole side and a negative pole side of the winding patterns.

FIGS. 16 and FIGS. 17 are plan views for explaining configurations of winding patterns at the winding conductor 1100 according to Embodiment 3. FIG. 16(a) through FIG. 16(c) indicate each of a winding pattern 101, a winding pattern 107, and a winding pattern 113, which compose the winding patterns at positive pole sides at a second layer, a third layer, and a fourth layer.

FIG. 17(a) through FIG. 17(c) indicate each of a winding pattern 116, a winding pattern 110, and a winding pattern 104, which compose the winding patterns at negative pole sides at a fifth layer, a sixth layer, and a seventh layer. In the noise filter according to Embodiment 3, the winding patterns at the second layer through the seventh layer are formed with a sequence of the winding pattern 101, the winding pattern 107, the winding pattern 113, the winding pattern 116, the winding pattern 110, and the winding pattern 104.

A winding pattern input terminal 103 at a positive pole side, a winding pattern input terminal 106 at a negative pole side, a winding pattern output terminal 114 at a positive pole side, and a winding pattern output terminal 118 at a negative pole side are provided at each of the winding patterns.

An end portion (or referred to as a connection position) 102 and an end portion 108 between terminals at the second layer and the third layer, which are positioned between the winding patterns, an end portion 109 and an end portion 115 between terminals at the third layer and the fourth layer, an end portion 117 and an end portion 112 between terminals at the fifth layer and the sixth layer, and a terminal portion 111 and an end portion 105 between terminals at the sixth layer and the seventh layer are electrically connected by using, for example, an inner via hole (IVH).

In this case, when an electric current density at a via hole portion is enhanced, a heating value at a via hole position is increased, so that it is desirable that a plurality of via holes are formed in a state where cross-sectional areas of the via holes are similar to cross-sectional areas of the winding patterns.

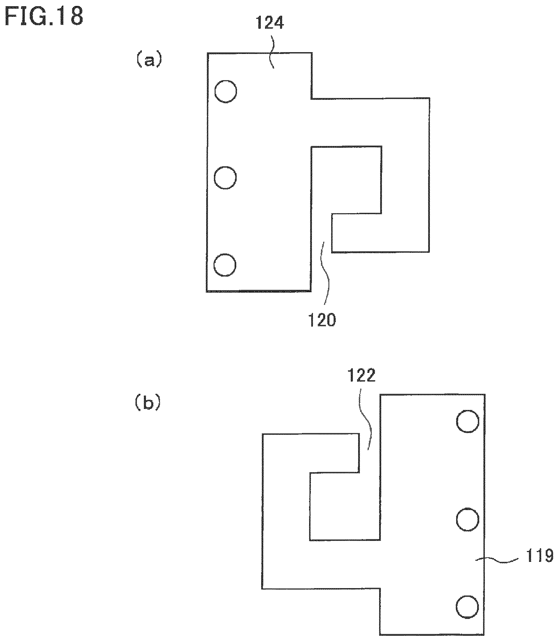

FIGS. 18 are plan views illustrating ground patterns of the noise filter according to Embodiment 3. FIG. 18(a) indicates a ground pattern 124 at the first layer, and FIG. 18(b) indicates a ground pattern 119 at the seventh layer, and capacitors to the ground are respectively formed between the first layer and the second layer and between the sixth layer and the seventh layer. It is required that a slit 120 and a slit 122 are provided at the ground pattern 124 and the ground pattern 119 in a similar way of the noise filter according to Embodiment 1.

Moreover, in reference to the grounding positions of the ground layer as described in Embodiment 1, it is required that the ground layer is grounded in such a way that a direction of a noise electric current (a noise electric current at an outward passage), which is flowed through the winding patterns, is reverse to a direction of a noise electric current (a noise electric current at a return passage), which is passed through the ground patterns and is flowed to a grounding electric potential. In the noise filter according to Embodiment 3, the grounding positions of the ground layer are respectively provided at one position of the positive pole side and at one position of the negative pole side.

### Embodiment 4

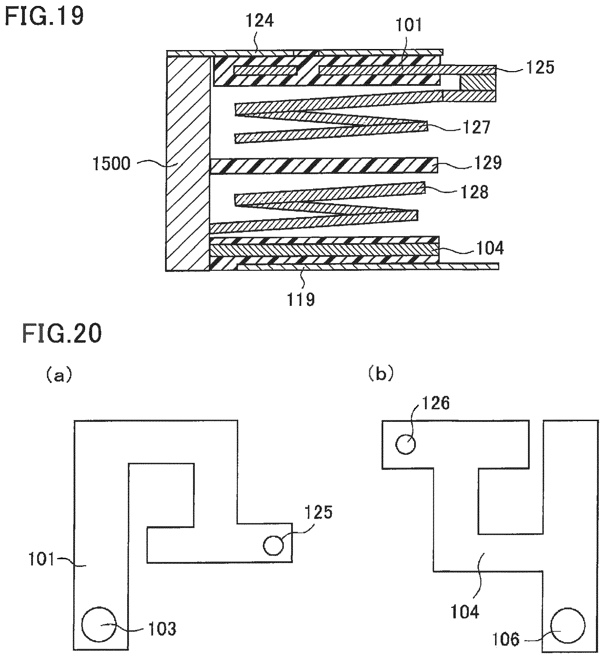

FIG. 19 is a cross-sectional view illustrating a common mode noise filter which is a noise filter according to Embodiment 4. A cross-sectional position is corresponding to the "B - B" line in FIG. 14 in which the noise filter according to Embodiment 3 is indicated. A winding 127 at a positive pole side and a winding 128 at a negative pole side are insulated by a spacer 129 which is made of an insulator.

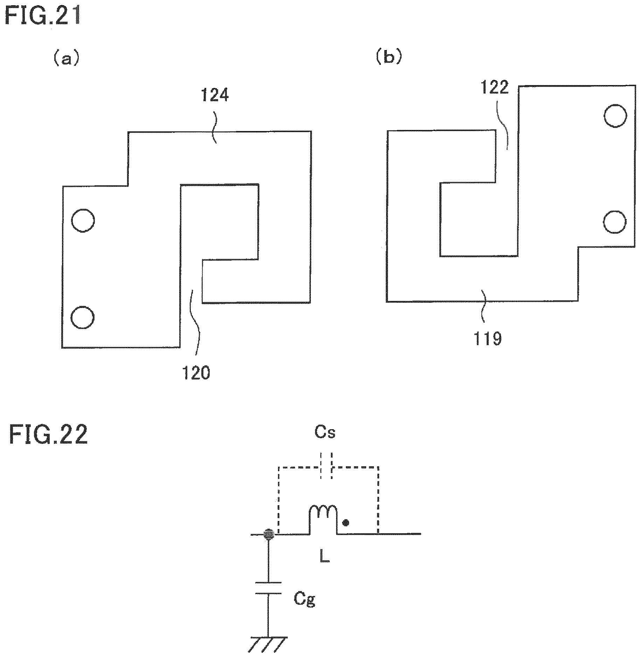

FIGS. 20 are plan views illustrating winding patterns of the noise filter according to Embodiment 4, and FIG. 20(a) indicates a positive pole side, and FIG. 20(b) indicates a negative pole side. FIGS. 21 are plan views illustrating ground patterns of the noise filter according to Embodiment 4, and FIG. 21 (a) indicates a positive pole side, and FIG. 21 (b) indicates a negative pole side. It is similar to the ground patterns according to Embodiment 1 that the ground patterns according to Embodiment 4 are extended to the outside of the winding patterns so as to be arranged at an input-output terminal position.

A ground pattern 124 and a winding pattern 101 at the positive pole side, by which a capacitor to the ground is formed, are integrated, for example, as a board, and a large capacitance is realized by using a dielectric which is positioned between the ground pattern 124 and the winding pattern 101. A capacitor to the ground at the negative pole side is similarly formed. A configuration of a portion, by which the above-described capacitor is formed, is similar to the configuration according to Embodiment 3.

In a configuration of the noise filter according to Embodiment 4, the winding 127 and the winding 128, which are components except for a component composing the capacitor, are not formed with a pattern according to Embodiment 3, and the winding 127 and the winding 128 are formed with, for example, a spiral shape.

As described above, a winding, which is not facing to a ground pattern of a winding conductor, is not formed by using a board pattern, and the winding is formed by using a sequential conductor, whereby a dielectric is not included between windings having an identical polarity, so that a capacitance between the windings can be decreased.

A capacitance (parasitic capacitance) Cs between the windings having an identical polarity is arranged, as indicated by using an equivalent circuit in FIG. 22, in parallel to an inductance (common mode inductance) L, so that a noise reduction capability of the noise filter can be improved when the capacitance Cs is decreased. A relation between the capacitance Cs and a capacitance Cg to the ground is indicated as FIG. 22.

In addition, a connection of the winding pattern 101 and a winding pattern 104, by which the capacitance Cg to the ground is formed, and a connection of the winding 127 and the winding 128 are performed by using a screw stopping process, a welding process or the like at a connection position 125 and a connection position 126.

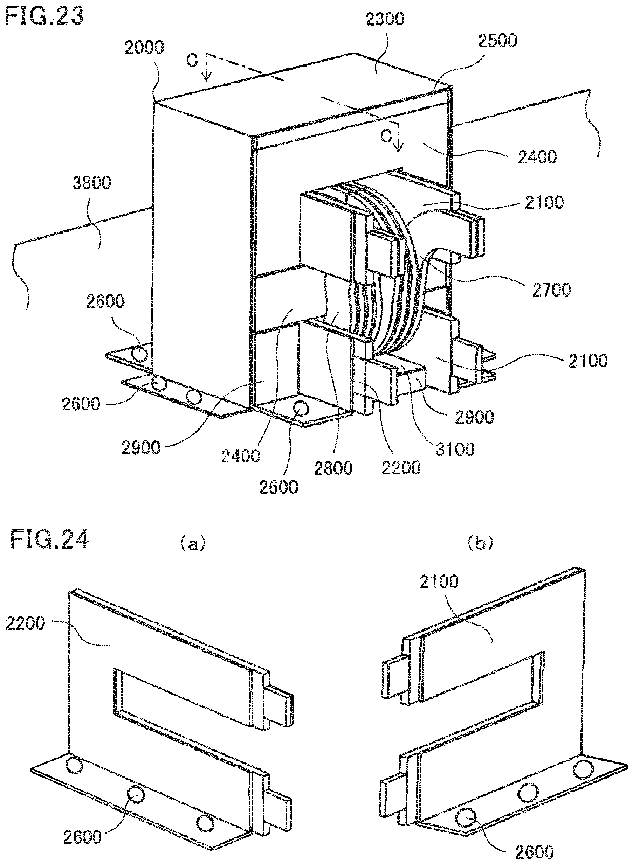

FIG. 23 is an oblique perspective view illustrating a noise filter 2000 according to Embodiment 5, and FIG. 23 indicates a state in which a radiating fin 3800 is attached. A winding conductor is formed with a spiral shape, as similar to the winding conductor according to Embodiment 4, and a dielectric is not included between the windings having an identical polarity, so that the capacitance between the windings can be decreased. Therefore, the capacitance, which is parallel to an inductance which is formed by using the windings and the magnetic material core, is decreased, and a noise reduction capability is improved.

FIGS. 24 are oblique perspective views in which a capacitor component 2100 and a capacitor component 2200, by which a capacitor of the noise filter according to Embodiment 5 is configured, are excerpted. FIG. 24(a) indicates the capacitor component 2100 at a positive pole side, and FIG. 24(b) indicates the capacitor component at a negative pole side.

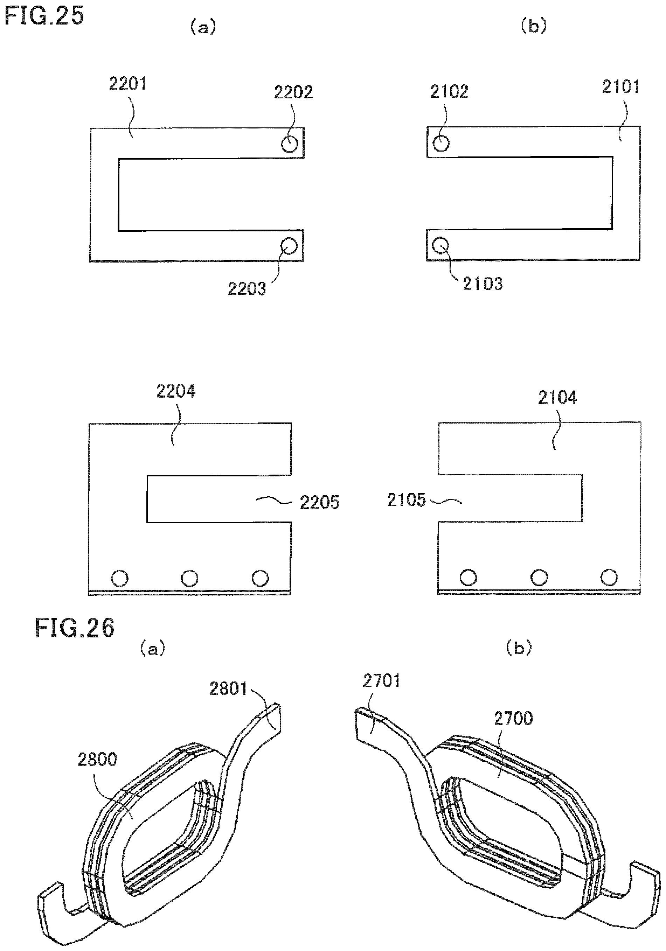

FIGS. 25 are views illustrating winding patterns and ground patterns of the capacitor component 2100 and the capacitor component 2200, by which the capacitor according to Embodiment 5 is configured. FIG. 25(a) indicates a winding pattern 2201 at the positive pole side and a ground pattern at the positive pole side, and FIG. 25(b) indicates a winding pattern at the negative pole side and a ground pattern at the negative pole side. It is similar to the noise filter according to Embodiment 1 that a ground pattern 2104 and a ground pattern 2204 are extended to the outside of the winding patterns so as to be arranged at an input-output terminal position 2103 and an input-output terminal position 2203, and a slit 2105 and a slit 2205 are formed.

It is similar to the noise filter according to Embodiment 1 that a dielectric resin is sandwiched between the winding pattern 2201 and a winding pattern 2101 and the ground pattern 2204 and the ground pattern 2104, and a capacitor is formed between the winding patterns and the ground patterns, and a function for reducing a noise is included.

The noise filter according to Embodiment 5 is different from the noise filters according to Embodiment 1 through Embodiment 4, and the noise filter according to Embodiment 5 has a characteristic in which the ground patterns are bent.

FIGS. 26 indicate winding conductors according to Embodiment 5, which are formed with a spiral shape, and FIG. 26(a) is an oblique perspective view illustrating a winding conductor 2800 at the positive pole side, and FIG. 26(b) is an oblique perspective view illustrating a winding conductor 2700 at the negative pole side. A terminal portion 2701 and a terminal portion 2801 are respectively and electrically connected to an input-output terminal position 2202 and an input-output terminal position 2102, which are indicated in FIGS. 25, by using a screw stopping process, a welding process or the like.

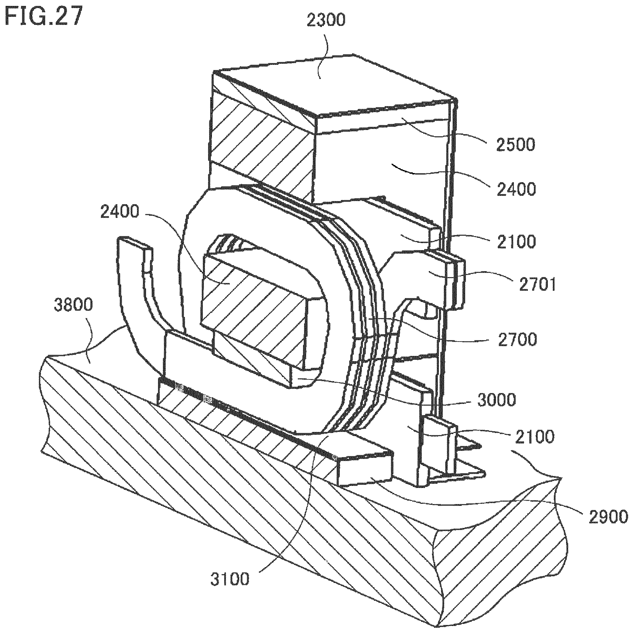

FIG. 27 is a cross-sectional view along a cutting line ("C - C" arrow view) which is indicated in FIG. 23. In the noise filter according to Embodiment 5, for example, a metallic pressing component 2300, by which a magnetic material core 2400 is pressed to the radiating fin 3800, is provided. In an example according to Embodiment 5, the winding conductor 2800 is pressed to the radiating fin 3800 by using, for example, a screw stopping process or the like, whereby a side surface of the winding conductor 2700 is pressed to an insulating sheet 3100 having a high heat conductivity via an insulating sheet 2500 having a high heat conductivity, the magnetic material core 2400, and an insulating spacer 3000.

In a case of an electric power conversion device having a large capacity, in which a large electric current, which is larger than or equal to several dozen amperes, is flowed, large joule heat is generated in accordance with a resistance component of a winding. As explained in Embodiment 1, the capacitor component 2100 and the capacitor component 2200, in which a capacitor is formed between the winding pattern and the ground pattern by using the dielectric, are used not only as a passage of a noise electric current but also as a propagation passage of heat to a radiating fin, so that the capacitor component 2100 and the capacitor component 2200 have an excellent heat radiation capability.

Therefore, a cross-sectional area of the winding conductor can be reduced, and as a result, the magnetic material core 2400 can be downsized, so that the whole of the noise filter can be downsized. Moreover, in the noise filter according to Embodiment 5, heat is propagated to the metallic component 2900, which is connected to the radiating fin 3800, through a side surface of the winding conductor via the insulating sheet 3100 having a high heat electric capability, so that a heat radiation capability of the noise filter is improved, the whole of the noise filter can be downsized.

In a case in which the magnetic material core 2400 has a high electric conductivity, when the winding conductor 2700 is directly pressed the insulating sheet 3100 by using the magnetic material core 2400, a noise electric current is flowed from the winding to the magnetic material core 2400, and a noise propagation passage, which bypasses the noise filter, is formed, and it is difficult that an effect of the noise filter is enhanced to a maximum effect, so that it is desirable that a material having an insulation capability is used.

Although a reason, in which the insulating sheet 3100 has an insulation capability, is similarly explained, in order to more reduce a contact heat resistance of the winding conductor 2700 and a metallic component 2900, it is desirable that the winding conductor 2700 and the metallic component 2900 are used by sandwiching a soft insulating sheet.

When the insulating spacer 3000 has a configuration in which a component having an insulation capability and a spring are combined, the winding conductor 2700 can be pressed to the insulating sheet 3100 by using an elastic force, whereby an allowable dimension error of the winding or a ferrite core is increased, so that there is an effect in which a manufacturing cost is reduced.

Moreover, when self-heat of the magnetic material core 2400 is generated, or heat is propagated from the winding conductor 2700 to the magnetic material core 2400, a temperature of the magnetic material core 2400 is raised. The magnetic material core 2400 generally has a property in which a characteristic is varied with respect to a temperature variation. In order to suppress the variation, it is desirable that the pressing component 2300, by which the magnetic material core 2400 is pressed, is made of a metal. A method, by which heat is propagated from the side surface of the winding conductor to the radiating fin 3800, which is described in Embodiment 5, is effective in the noise filter, which is covered by an insulator, according to Embodiment 1.

In addition, in the scope of the present invention, it is possible that each of embodiments are freely combined with each other, or each of the embodiments is suitably modified or features are omitted therein.

### Description of the Symbols

- 100, 1100, 2700, 2800: winding conductors
- 200, 1200: dielectrics (dielectric resins)
- 400, 1400, 2400: magnetic material cores
- 700, 1700, 2000: noise filters (common mode noise filters)
- 800, 1800: radiating fins
- 801: groove
- 1, 4, 7, 10, 13, 16, 101, 104, 107, 110, 113, 116,: 2102, 2201 winding patterns
- 19, 24: ground conductors
- 19a, 19b, 24a, 24b, 119, 124, 2104, 2204: ground patterns
- 20, 21, 22, 23, 25, 26, 27, 28, 120, 122, 2105, 2205: slits

## Claims

1. A noise filter comprising:
- a winding conductor which is composed of a conductor having a plane shape, and composes winding patterns which are arranged with a layer shape and electrically connect a component between layers;
- ground conductors, which are arranged in a state where a dielectric is sandwiched between the ground conductors and conductors of the winding patterns, and compose ground patterns; and
- a magnetic material core to which the winding patterns are wound;
- wherein the ground patterns are extended to the outside of the winding patterns so as to be arranged at positions where the ground patterns are faced to input-output terminals of the winding patterns; and slits, which separate portions which are arranged around the magnetic material core, are provided at the ground patterns of the ground conductors.

2. The noise filter as recited in claim 1,
wherein an input-output terminal of the winding conductor is provided at an outer circumference side of a magnetic flux by which a closed magnetic passage is formed in a core of the magnetic material core.

3. The noise filter as recited in claim 1,
wherein the winding patterns are formed with a board shape at the winding conductor, and a plurality of the winding patterns are respectively provided, and the winding patterns are magnetically linked each other.

4. The noise filter as recited in claim 1,
wherein the ground patterns and the winding patterns are arranged in such a way that positions of the slits, which are provided at the ground patterns of the ground conductors, and positions of slits, which are provided at the winding patterns of the winding conductor which is faced via the dielectric, are overlapped.

5. The noise filter as recited in claim 1,
wherein a radiating fin, which is connected to the ground patterns of the ground conductors, is provided.

6. The noise filter as recited in claim 5,
wherein a groove, by which the magnetic material core is stored, is provided at the radiating fin, and the ground patterns of the ground conductors are connected to the radiating fin in a state where the magnetic material core is stored in the groove.

7. The noise filter as recited in claim 1,
wherein a winding, which is not faced to the ground patterns of the winding conductor, is formed by using a continuous line.

8. The noise filter as recited in claim 1,
wherein a plurality of the noise filters is connected in series.

9. The noise filter as recited in claim 7,
wherein a side surface of the winding conductor is contacted to a radiating fin via an insulating material.

10. The noise filter as recited in claim 9,
wherein a pressing component, by which the magnetic material core is pressed to the radiating fin, is provided.

11. The noise filter as recited in claim 10,
wherein an insulating component is provided between the winding conductor and the magnetic material core.

12. The noise filter as recited in claim 1,
wherein the dielectric is contacted to a radiating fin.
